# EUROPEAN PATENT SPECIFICATION

(11) **EP 0 410 747 B1**
(45) Date of publication and mention of the grant of the patent: **21.09.1994**
(21) Application number: 90308194.1
(22) Date of filing: 26.07.1990
(51) Int. Cl.: B05C 21/00, B32B 7/06

(54) **Conductive masking laminate**
Leitfähiger Maskierungsverbundstoff
Masque stratifié conducteur

(30) Priority: 28.07.1989 US 386393; 25.06.1990 US 543604
(43) Date of publication of application: 30.01.1991
(73) Proprietor: CHOMERICS, INC., Woburn Massachusetts 01888 (US)
(72) Inventor: Keyser, Paul F., W. Newbury, Massachusetts 01985 (US); Jones, Peter M., Londonderry, New Hampshire 03053 (US); Hubbard, John Dana, Billerica, Massachusetts 01821 (US); Farrell, Theresa, N. Andover, Massachusetts 01845 (US)
(74) Representative: Barlow, Roy James

(56) References cited:
- EP-A- 0 203 635
- EP-A- 0 303 268
- GB-A- 1 315 516
- US-A- 3 497 383
- US-A- 4 851 071
- PATENT ABSTRACTS OF JAPAN (C-178)(7171) July 28, 1983 & JP-A-58 079 569 (TOMOO TATE) May 13, 1983

## Description

The present invention relates to a conductive maskable EMI tape for metal cabinets. More specifically, it relates to a masking tape for EMI shielding applications.

### BACKGROUND OF THE INVENTION

Manufacturers of EMI shielded cabinetry, such as computer cabinets, need to provide a clean conductive surface on the support frames and enclosure panels onto which the EMI shielding may be attached. This has required a bare or plated surface be formed in these areas. A plated surface is preferred as it provides areas of high conductivity and corrosion resistance. The remainder of the cabinet is generally painted with an electrostatic discharge coating or a finish coat of paint. The plated areas need to be masked during the painting sequence. The mask is then stripped away, the EMI shielding is applied and the cabinet is assembled.

While this method has proven to be acceptable to the cabinet industry, the cost of plating such cabinets has increased dramatically due in part to the environmental considerations involved in such plating processes as well as the scarcity of platers and the cost of transporting the parts to and from the plater.

An alternative to the plating of the cabinet surfaces consists of a conductive metal foil having one side coated with a pressure sensitive conductive adhesive and the other side covered with a peelable plastic film such as a Mylar® plastic film. The product is known as CHO-MASK® and is available from Chomerics, Inc. The masking tape is applied to the desired areas of the cabinet which is then painted or provided with a finish coat. The cover film is then removed to reveal a conductive, noncorrosive surface to which the EMI shielding gasket is mated. The mask had one of two different peelable surfaces depending upon whether the finish coat on the cabinet was subjected to a bake cycle. If so, the peelable coat is designed to release upon being heated.

While generally acceptable, this mask system has several disadvantages. Customer confusion as to which type of peel system to use often led to the use of the improper mask which resulted in the failure of the mask to either withstand the bake cycle or peel at room temperature. Additionally, the peel system used in the bake cycle applications has to be removed while still hot, due to the adhesive system that is used. This type of mask is difficult if not impossible to remove when at room temperature and often results in rips or tears in the conductive foil which reduces the EMI shielding capability of the system in those locations. Further, an adhesive residue remaining on the foil surface after the cover layer must be removed. This residue can affect the shielding capabilities of the foil and thus required the additional step of cleaning the foil surface before applying the EMI shielding. Perhaps most importantly, as the cover layer is removed it tends to chip or nick the paint along the edges of the foil, leaving exposed unplated areas of the cabinet which can be subject to corrosion. Further, these nicks or chips allow air to get under the conductive foil which can subject the conductive adhesive layer to oxidation and subsequent failure.

JP-A-58/079569 discloses a masking laminate comprising a low melting point adhesive layer with a metal foil layer adhered to its upper surface, and with one or more adhesive strips formed along the metal foil on the face opposite that carrying the adhesive layer, the strips running parallel to an outer edge of the metal foil. The laminate is applied to an area to be masked and the metal foil is adhered thereto by the application of heat and pressure to melt the adhesive layer. A release layer and a base layer used to support this metal foil during application and adhesion are then stripped from the metal foil before the painting is started. After painting, the metal foil is stripped from the masked surface using a high tack strength adhesive stripping tape.

### SUMMARY OF THE INVENTION

The present invention overcomes the shortfalls of the prior masking materials, providing a conductive mask that is easy to install, does not cause corrosion of the metal cabinet or oxidation of the conductive adhesive layer and which provides at least one adhesive-free area on the outer surface of the mask to which an EMI shield may be mated.

The masking laminate of the present invention is defined in claim 1.

The method of this invention is defined by claim 14.

The preambles of claims 1 and 14 are based on JP-A-58/079569.

### DESCRIPTION OF THE DRAWINGS

Figure 1 shows a cross-sectional view taken across the width of a preferred embodiment of the present invention.

Figure 2 shows the embodiment of Figure 1 after having been installed to a substrate and subsequently treated.

Figure 3 shows a cross-sectional view taken across the width of another preferred embodiment of the present invention.

Figure 4 shows another preferred embodiment of the present invention in a cross-sectional view.

Figure 5 shows a further preferred embodiment of the present invention in a cross-sectional view.

Figure 6 shows a preferred embodiment of the present invention in cross-sectional view utilizing one layer of adhesive strip.

### DETAILED DESCRIPTION OF THE INVENTION

The present invention is a conductive laminate or tape which can be used as mask for use in EMI shielding applications.

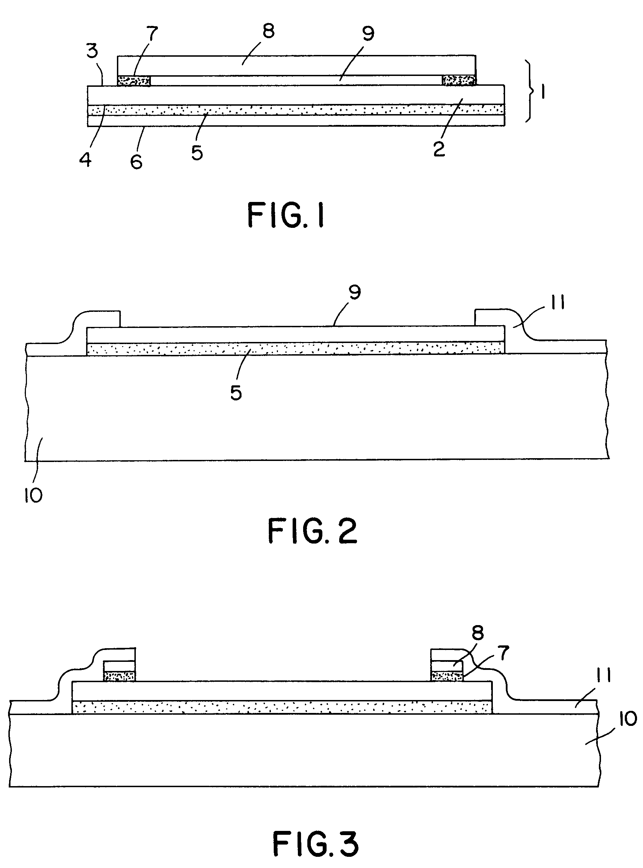

Figure 1 shows a preferred embodiment of the present invention. The tape 1 has a conductive metal foil layer 2 having an upper surface 3 and lower surface 4. An adhesive layer 5, preferably electrically conductive, is coated on the lower surface 4 of the foil 2. Preferably, the adhesive layer is covered by a release layer 6. The upper surface 3 has a plurality of adhesive strips 7 which extend along the length of the foil layer 2, are spaced apart from each other and are parallel to the outer edges of the foil layer. A mask layer 8 is attached to the upper surface of the adhesive strips 7. The mask layer 8 covers one or more centrally located adhesive-free areas 9 of the foil layer 2.

The tape of Figure 1 is applied to a substrate 10 such as a steel cabinet frame or door as shown in Figure 2. The substrate with the tape is then subjected to one or more finish treatments such as the formation of a protective coating 11 on the substrate 10. At least a portion of the mask is then removed to expose the centrally located adhesive-free area 9. An EMI shield such as a conductive gasket is mounted or mated to the adhesive-free area 9 of the tape and the substrate is then joined to another substrate via the shield to establish electrical continuity between the substrates and form an EMI shielded cabinet, enclosure, etc.

The mask layer may either be completely removable as shown in Figure 2 or only a central portion of the mask layer may be removable as shown in Figure 3.

The width of the mask layer maybe equal to or less than the width of the foil layer. Preferably, the width of the mask layer is less than the width of the foil layer, especially when it is desired to remove the entire mask layer, as shown in Figure 2. The width of the mask layer that is removable is always sufficiently narrow so that when removed, any chipping of the paint or finish coat that may occur does not extend to the edge of the foil layer or beyond. This prevents the corrosion of the substrate. Additionally, it also ensures that the paint forms an oxygen barrier along the edges of the foil and adhesive layer so that the foil and adhesive layer are not subjected to oxidation or corrosion.

In the embodiment of Figure 2, where the entire mask and adhesive strip portions are removed, it is preferred that the adhesive strips have sufficient adhesive strength to retain the mask until its desired removal, but also they should have the ability to peel away cleanly and completely when removed.

When only a portion of the mask is removed, as shown in Figure 3, it is preferred that at least the portion of the mask over the adhesive free area of the foil be removable. It is more preferred that the removable portion of the mask extend from at least the inner edge of the outermost adhesive strip on one side of the foil to at least the inner edge of the outermost adhesive strip on the other side of the foil.

One preferred means for forming such a removable mask portion is to use a series of perforations along the desired mask portions such that the mask is held in place until the perforations are ruptured, generally by a worker grabbing the portion of the mask over the adhesive free area of the foil and pulling on that portion of the tape. Another means for forming the removable portion of the mask is to cut the mask portion which lies on top of the adhesive strips such that the adhesive portion of the strip, inward of the cut, retains the mask in place until its desired removal. Other similar means for forming the removable portion may also be used.

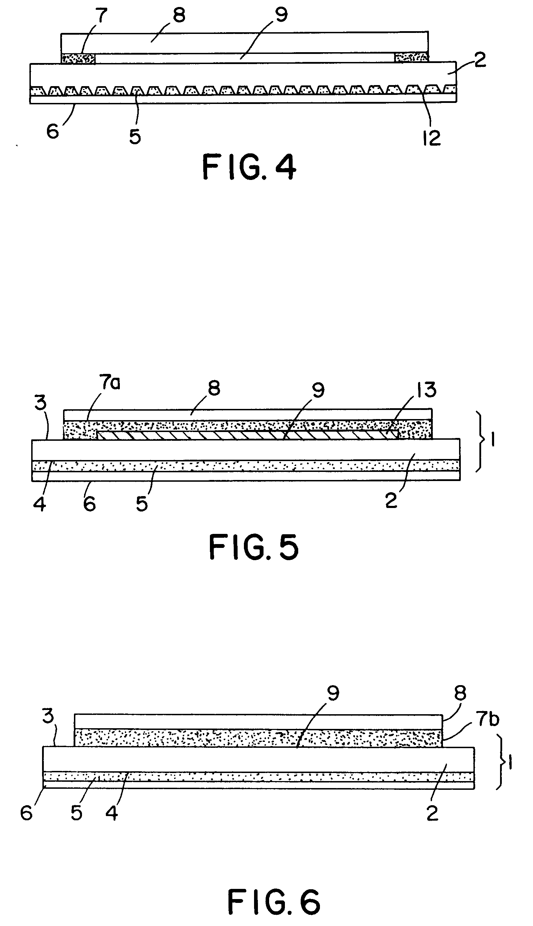

In an alternative embodiment, one large adhesive strip replaces the two or more smaller strips 7 of Figure 1. In this embodiment, as shown in Figure 5, the adhesive free area 9 of the foil 2 is first covered by a plastic film 13, such as a MYLAR® film, having a width corresponding to that of the area 9. The adhesive strip 7a is then coated over that plastic film and a mask layer 8 is attached to its surface. The mask, adhesive and plastic film may be removed by any of the means discussed above.

In a second alternative embodiment, one adhesive strip 7b, similar to that of the embodiment of Figure 5, replaces the two or more smaller strips of Figure 1. In this embodiment, unlike that of Figure 5, the adhesive strip 7b covers the adhesive free area 9 of the foil 2 rather than the plastic film 13 of Figure 5. A mask layer 8 is then placed over and adhered to the adhesive layer 7b. In this embodiment, it is desirable that the adhesive layer and mask be of about the same width and that width be less than that of the foil layer so as to form an indented or stepped arrangement so as to prevent chipping, corrosion or oxidation of the foil and/or substrate to which it is attached.

It is preferred in this embodiment that the entire adhesive strip and mask be removable and that the adhesive have sufficient adhesive strength to retain the mask until its desired removal, but also be capable of being removed cleanly and completely. Additionally, it is preferred that the amount of adhesive used be minimized so as to reduce the possibility of leaving any adhesive residue. Preferably, the adhesive strip has a thickness of less than about 127µm (.005 inches), more preferably about 25µm to 76µm (.001 to .003 inches) and most preferably about 25µm (.001 inches).

Alternatively, the adhesive strip and mask may have only a removable central portion which overlays the adhesive free area 9b, similar to that of the embodiment of Figure 3. In this instance, it is preferred that the mask and adhesive be cut completely through so that they are easily removable when desired and do not tend to pull the adjacent remaining portions with them.

Suitable strip/mask combinations can be formed from plastic films having a pressure-sensitive adhesive coated on one surface, as discussed further hereinbelow. Optionally, a high temperature nylon tape made by Minnesota Mining & Manufacturing under No. 855 may be used. This tape is a 51µm (2 mil) thick nylon tape backing having a 25µm (1 mil) thick cured, non-silicone adhesive. The product is described as being capable of withstanding high temperatures and stripping cleanly away.

The metal foil layer may be formed of any electrically conductive metal. It may also consist of a laminate of two or more metal foils. Preferably, the selected metal is non-corrosive, highly conductive, and has a high tensile strength in a thin sheet form. Such metals include but are not limited to gold, silver, aluminum, tin, zinc, nickel, copper, platinum, palladium, iron and its alloys, steel, stainless steel and various alloys of such metals. Additionally, the foil may be a plated, coated or clad metal foil, such as a noble metal coated non-noble metal foil. The noble metal coating, plating or cladding on non-noble metal foils is preferred as it is not subject to corrosion or oxidation and is highly conductive. Such foils include but are not limited to silver-coated copper, aluminum, zinc, iron, iron alloys, steel including stainless steel, nickel or cobalt; gold-coated copper, aluminum, tin, zinc, iron, iron alloys, steel including stainless steel, nickel or cobalt. Additionally, various non-noble metal coated or plated foils may be used. Such foils include but are not limited to tin coated copper, tin-coated aluminum and nickel-coated copper.

The metal foil layer should be strong, ductile and relatively thin so as to be resistant to tearing and to be self supportive. Preferably the foil layer is from about 13µm to 508µm (.0005 to .020 inches) thick, more preferably about 25µm to 254µm (0.001 to 0.010 inches) thick and most preferably about 50µm to about 125µm (about 0.002 to about 0.005 inches) thick.

In another embodiment, as shown in Figure 4, the metal foil may contain a series of projections (12) formed in its surface which extend toward the bottom side 4 of the foil 2. The height of the projections should be substantially equal to or greater than the thickness of the adhesive layer on the bottom surface of the foil so that the projections themselves establish the conductive pathway between the foil and the substrate to which it is adhered. Preferably, the projections are embossed, calendered or needle-punched after the foil has been coated with the adhesive layer. In this embodiment, it-is not necessary that the adhesive layer be electrically conductive, however it is a preferred embodiment.

The adhesive layer coated on the bottom side of the foil layer is preferably electrically conductive although as discussed above, it need not be conductive if another means of establishing electrical conductivity between the foil and the substrate to which it is adhered is used. Preferably, the adhesive is pressure-sensitive. By pressure-sensitive, it is meant that the adhesive establishes a tight bond with the substrate to which it is applied under normal finger or hand pressure. Such adhesives generally do not require additional curing steps to form an adequate bond and therefore they are generally preferred in this application. Suitable pressure-sensitive adhesives are well known and generally are formed from various rubbers, natural and synthetic, such as silicone, fluorosilicone and neoprene rubber, or synthetic polymers such as styrene butadiene copolymers and other such elastomeric copolymers, acrylics, acrylates, polyvinyl ethers, polyvinyl acetate copolymers, polyisobutylenes and mixtures thereof. An acrylic pressure-sensitive adhesive is preferred. If a pressure-sensitive adhesive is not used, then other well known adhesives may be used, including for example, epoxy or urethane adhesives. If the adhesive is electrically conductive, it generally contains one or more conductive fillers in an amount sufficient to provide the desired conductivity The fillers can be of any shape and size useful in such adhesives. Generally, the fillers are in the form of particles, flakes or fibers. The fillers may be of a size from submicron to about 400µm across their largest diameter. Generally, fillers range in size from about 1 to 100µm, more preferably about 20 to about 60µm. The amount of filler should be sufficient to provide the desired electrical conductivity. Amounts generally range from about 1% by total weight of filler and adhesive to about 25% by total weight of filler and adhesive. Preferably, the amount of filler is from about 5% to 15% by total weight. The one or more electrically conductive fillers include but are not limited to solid metal fillers or solid carbon or graphite fillers. The fillers may also be plated particles such as noble metal plated metals, plastics or glass including but not limited to silver-coated copper powder, silver-coated glass, and silver-coated plastic. The means by which the adhesive is rendered conductive is not critical to the invention and any suitable means that provides the desired conductivity and adhesion may be used.

As described above, the adhesive layer is preferably covered by a release layer 6 until used. Release layers are well known and commonly are formed of a coated paper or plastic sheet which has the ability to adhere to the adhesive layer so as to be removable under slight pressure without injuring the adhesive layer.

The one or more strips of adhesive used on the upper side of the foil layer should provide adequate adhesion between the foil and mask layer so that the mask is not removed until desired. As discussed in reference to the embodiments of Figures 3 and 6, a portion of the one or more adhesive strips and the mask may remain adhered to the foil surface after removal of the center portion, with the mask having a series of perforations running along the length of the mask so that the portion of the mask and/or adhesive strip above the adhesive-free area of the tape can be removed when desired. Alternatively, the adhesive can be a release type of adhesive such that it is removed with the mask when the mask is peeled. This embodiment is shown in Figures 2 and 6. The one or more adhesive strips should be capable of withstanding the range of temperatures normally encountered in the painting/coating of such cabinets, including elevated temperatures at which a paint or coating may be baked to obtain a cured finish. It is not necessary that the one or more adhesive strips be pressure-sensitive, though they may be if so desired.

Such adhesives are well known and commercially available. Such adhesives include but are not limited to the adhesives described above in relation to the adhesive layer of the present invention.

The dimensions of each strip should be sufficient to allow for the proper retention and release of the mask and to allow for the formation of one or more adhesive-free areas on the metal foil layer. As a guide, the total width of the strips should be about 25% or less of the width of the foil layer when two or more strips are used. With the width of tapes normally considered in this invention, such strips should be about 13µm to about 125µm (about 0.0005 to about 0.002 inches) in thickness and about 1,5mm to about 6,4mm (about .0625 to about .25 inches) in width. When one strip is used, as shown in Figures 5 and 6, the width of the strip is preferably less than the width of the foil, yet it should substantially cover the foil's surface. Preferably, when one strip is used it is substantially the same width as the mask that is applied above it. The strips are preferably continuous along the length of the metal foil, however, if desired, they may be formed intermittently along the length of the foil so long as it prevents the paint or finish coat from penetrating and covering the adhesive-free area of the foil. Additionally, a plurality of strips may be used to form one or more adhesive-free areas on the foil layer. Such an embodiment may be useful where two or more EMI shields are being used.

The mask material should be self supportive and essentially impervious so as to prevent the paint or finish coat from penetrating and covering the adhesive-free area of the metal foil. Preferred materials are plastic films, either thermoplastic or thermoset, such as polyamides, polyimides, polyethylenes, nylons and other olefinic polymers, polycarbonates, polyethylene terephthalates. Cellulosic films may also be used. Additionally, various coated papers, woven and non woven fabrics which are impervious to the finish coat may also be used. Likewise, if desired, one may also use a metal foil layer for the mask layer. One preferred mask/adhesive combination is commercially available from Minnesota Mining & Manufacturing as Industrial Tape No. 855 and as described hereinbefore as a nylon-based tape having a non silicone adhesive that is resistant to high temperatures and is capable of providing a clean removal from the surface of the metal foil.

The tape system may vary in width depending upon that desired or required for the application. The tape should be sufficiently wide so that the EMI shield to which it is mated has an adequate adhesive-free foil surface to contact. Generally, the tape may be from about 6,4mm to about 305mm (about .25 inches to about 12 inches) in width. Preferably, the tape is from about 19mm to about 100mm (about .75 inches to about 4 inches) in width.

The thickness of tape before application to a substrate should be about 76µm to 381µm (.003 inches to .015 inches) (including the release layer). Preferably, the tape is less than 254µm (.010 inches) thick.

A tape according to the invention may be formed by several different processes. One such process is to form the tape as a laminate as follows:

A metal foil of tinned copper about 38mm (1.5 inches) in width is coated on one side with an electrically conductive pressure-sensitive acrylic adhesive. A release paper is then placed over the adhesive to prevent its premature adherence to a substrate. Two adhesive strips formed of a pressure-sensitive non conductive acrylic adhesive are then coated along the opposite side of the foil. The strips, approximately 3,2mm (.125 inches) in width, are spaced apart so as to form at least one adhesive free area about 12,7mm (.5 inches) in width on the central portion of foil surface. Additionally, the strips are spaced or indented from the outer edges of the foil layer by about 3,2mm (.125 inches). A mask layer formed of a MYLAR® film, about 32mm (1.25 inches) in width is centered over the strips and adhered thereto.

The tape is mounted by cutting the tape to length, peeling the release layer from the conductive adhesive layer and adhering the tape to the substrate. The substrate, such as a computer cabinet, is then treated with a finishing coat, such as paint such that it covers the entire tape surface.

After allowing the paint to dry and/or cure, the mask portion is stripped from the tape to expose the adhesive free area. An EMI shielding device, such as a conductive elastomeric or metal mesh gasket, is then attached to the adhesive-free area and the substrate is then mated with another substrate, such as a cabinet door to complete the installation.

The present invention provides several advantages. It eliminates the chipping of the paint or finish coat along the edge of the metal foil which caused corrosion of the substrate and/or failure of the previous mask systems. It provides a consistently removable mask that is not dependent upon a high temperature to ensure its release. Lastly, it eliminates the need for plating of the substrate which is costly and time consuming and which poses a potential threat to the environment.

## Claims

1. A masking laminate comprising an adhesive layer (5), a metal foil layer (2) adhered to an upper surface of the adhesive layer, one or more adhesive strips (7)(7a)(7b) formed along a length of the metal foil layer on a side opposite to the adhesive layer, the one or more adhesive strips running parallel to an outer edge of the metal foil, and at least one releasable mask layer (8) adhered to an upper surface of the one or more adhesive strips, characterised in that the said one or more adhesive strips are adjacent to one or more adhesive-free areas (9) on a surface of the foil layer (2); in that at least one of the adhesive-free areas is centrally located on the foil layer; and in that said at least one releasable mask layer (8) covers a said adhesive-free area (9).

2. A laminate according to claim 1 wherein the adhesive layer is a pressure-sensitive adhesive; and the metal foil layer is selected from the group consisting of conductive metal foils, conductive metal alloys and conductive plated metal foils.

3. A laminate according to claim 1 or 2, wherein the adhesive layer is electrically conductive.

4. A laminate according to claim 3 wherein the adhesive layer is an electrically conductive pressure-sensitive adhesive.

5. A laminate according to any one of claims 1 to 4, wherein the metal foil layer has a series of projections (12) which extend through the adhesive layer.

6. A laminate according to claim 5, wherein the height of the projections (12) is equal to the thickness of the adhesive layer (5).

7. The laminate of any one of claims 1 to 6 wherein the mask layer has a width equal to or less than the width of the foil layer.

8. The laminate of any one of claims 1 to 6 wherein the mask layer has a width substantially equal to the width of the foil layer and the mask layer has a series of perforations formed parallel to the margins of the foil but inward from the margins of the foil.

9. A laminate according to any one of claims 1 to 8 wherein the width of the mask layer and the width of the one or more adhesive strips are equal and the width of the mask and the width of the one or more adhesive strips is less than the width of the metal foil layer.

10. A laminate according to any one of claims 1 to 9 and further comprising a release layer (6) bonded to an outer surface of the adhesive layer.

11. A laminate according to any one of claims 1 to 10 wherein there is only one said adhesive strip (7a) which covers a said adhesive-free area on the top side of the foil layer, and a releasable film (13) between said adhesive strip and said adhesive-free area of the metal foil layer.

12. A masking laminate according to any one of claims 1 to 11 wherein the metal foil layer is selected from the group consisting of silver foil, gold foil, platinum foil, palladium foil, copper foil, aluminum foil, tin foil, zinc foil, cobalt foil, nickel foil, iron foil, stainless steel foil, silver-plated copper foil, silver-plated aluminium foil, silver-plated nickel foil and tin-plated copper foil; the adhesive layer is selected from the group consisting of non electrically conductive pressure-sensitive adhesives and electrically conductive pressure-sensitive adhesives; and the mask layer is selected from the group consisting of polymeric films, coated paper, woven and non-woven fabrics, and metal foils.

13. The masking laminate of claim 12, wherein a portion of the mask layer and adhesive strip, both having a width substantially equal to or greater than the width of the adhesive free area, are removable from the rest of the mask layer.

14. A laminate according to any one of claims 1 to 4, wherein there is one said adhesive strip (7b) which is capable of being completely removed from the metal foil, on use, to expose said adhesive-free area (9).

15. A method of masking a surface for the application of a protective coating, comprising applying to part of said surface to be coated a masking laminate (2,5,8) including a metal foil (2) having an adhesive layer (5) for securing it to the surface (10) to be masked, and including a releasable masking layer (8) mounted by a further adhesive (7,7a,7b) on the opposite side of the metal foil (2) from that contacting the adhesive (5), and then subsequently both applying a surface coating to the non masked areas of the surface and removing at least part of the masking laminate, characterised in that the part of the masking laminate which is removed is the masking layer (8) and the further adhesive (7), (7a), (7b) after application of the coating, thereby leaving exposed an adhesive-free area (9) of the metal foil (2).

## Patentansprüche

1. Maskierungsverbundstoff, der eine Klebeschicht (5), eine Metallfolienschicht (2), die an der oberen Oberfläche der Klebeschicht haftet, einen oder mehrere Klebestreifen (7) (7a) (b), die entlang einer Länge der Metallfolienschicht auf einer Seite gebildet sind, die der Klebeschicht entgegengesetzt ist, wobei der eine oder die mehreren Klebestreifen parallel zu einem Außenrand der Metallfolie verlaufen, und mindestens eine abtrennbaren Maskenschicht (8) umfaßt, die an einer oberen Oberfläche des einen oder der mehreren Klebestreifen haftet, dadurch gekennzeichnet, daß der eine oder die mehreren Klebestreifen an eine oder mehrere kleberfreie Flächen (9) auf einer Oberfläche der Folienschicht (2) angegrenzen, mindestens eine der kleberfreien Flächen zentral auf der Folienschicht angeordnet ist und die mindestens eine abtrennbare Maskenschicht (8) diese kleberfreie Schicht (9) bedeckt.

2. Verbundstoff nach Anspruch 1, bei dem die Klebeschicht aus einem Haftkleber besteht und die Metallfolienschicht ausgewählt ist aus der Gruppe bestehend aus leitfähigen Metallfolien, leitfähigen Metallegierungsfolien und leitfähigen, plattierten Metallfolien.

3. Verbundstoff nach Anspruch 1 oder 2, bei dem die Klebeschicht elektrisch leitfähig ist.

4. Verbundstoff nach Anspruch 3, bei dem die Klebeschicht aus einem elektrisch leitfähigen Haftkleber besteht.

5. Verbundstoff nach einem der Ansprüche 1 bis 4, bei dem die Metallfolienschicht einer Reihe von Vorsprüngen (12) aufweist, die sich durch die Klebeschicht erstrecken.

6. Verbundstoff nach Anspruch 5, bei dem die Höhe der Vorsprünge (12) gleich der Dicke der Klebeschicht (5) ist.

7. Verbundstoff nach einem der Ansprüche 1 bis 6, bei dem die Maskenschicht eine Breite aufweist, die der Breite der Folienschicht gleicht oder geringer ist.

8. Verbundstoff nach einem der Ansprüche 1 bis 6, bei dem die Maskenschicht eine Breite aufweist, die der Breite der Folienschicht im wesentlichen gleicht und die Maskenschicht eine Reihe von Vorsprüngen aufweist, die parallel zu den Rändern der Folie aber einwärts von den Rändern der Folie ausgebildet sind.

9. Verbundstoff nach einem der Ansprüche 1 bis 8, bei dem die Breite der Maskenschicht und die Breite des einen oder der mehreren Klebestreifen gleich sind und die Breite der Maske und die Breite des einen oder der mehreren Klebestreifen kleiner ist als die Breite der Metallfolienschicht.

10. Verbundstoff nach einem der Ansprüche 1 bis 9, der ferner eine Trennschicht (6) umfaßt, die an eine äußere Oberfläche der Klebeschicht gebunden ist.

11. Verbundstoff nach einem der Ansprüche 1 bis 10, bei dem nur ein Klebestreifen (7a), der eine kleberfreie Fläche auf der Oberseite der Folienschicht bedeckt, und eine abtrennbare Folie (13) zwischen dem Klebestreifen und der kleberfreien Fläche der Metallfolie vorhanden sind.

12. Maskierungsverbundstoff nach einem der Ansprüche 1 bis 11, bei dem die Metallfolienschicht ausgewählt ist aus der Gruppe bestehend aus Silberfolie, Goldfolie, Platinfolie, Palladiumfolie, Kupferfolie, Aluminiumfolie, Zinnfolie, Zinkfolie, Kobaltfolie, Nickelfolie, Eisenfolie, Edelstahlfolie, silberplattierter Kupferfolie, silberplattierter Aluminiumfolie, silberplattierter Nickelfolie und zinnplattierter Kupferfolie, die Klebeschicht ausgewählt ist aus der Gruppe bestehend aus elektrisch nicht-leitfähigen Haftklebern und elektrisch leitfähigen Haftklebern und die Maskenschicht ausgewählt ist aus der Gruppe bestehend aus polymeren Folien, beschichtetem Papier, gewebten und ungewebten Stoffen und Metallfolien.

13. Maskierungsverbundstoff nach Anspruch 12, bei dem sowohl ein Teil der Maskenschicht als auch ein Teil der Klebestreifen eine Breite aufweisen, die im wesentlichen gleich oder größer ist als die Breite der kleberfreien Fläche, und von dem Rest der Maskenschicht entfernbar sind.

14. Verbundstoff nach einem der Ansprüche 1 bis 4, bei dem nur ein Klebestreifen (7b) vorhanden ist, der vollständig von der Metallfolie beim Gebrauch entfernt werden kann, um die kleberfreie Fläche (9) freizulegen.

15. Verfahren zur Maskierung einer Oberfläche für die Aufbringung einer Schutzbeschichtung, bei dem auf die zu beschichtende Oberfläche ein Maskierungsverbundstoff (2,5,8) aufgebracht wird, der eine Metallfolie (2) mit einer Klebeschicht (5) zu ihrer Befestigung an der zu maskierenden Oberfläche (10) aufweist und eine abtrennbare Maskierungsschicht (8) einschließt, die durch einen weiteren Kleber (7, 7a, 7b) auf der Seite der Metallfolie (2) angebracht ist, die derjenigen entgegengesetzt ist, die den Kleber (5) kontaktiert, und dann anschließend sowohl eine Oberflächenbeschichtung auf die unmaskierten Flächen der Oberfläche aufgebracht wird als auch mindestens ein Teil des Maskierungsverbundstoffs entfernt wird, dadurch gekennzeichnet, daß der Teil des Maskierungsverbundstoffs, der entfernt wird, die Maskierungsschicht (8) und der weitere Kleber (7), (7a), (7b) ist, wodurch nach der Aufbringung der Beschichtung eine kleberfreie Fläche (9) auf der Metallfolie (2) freiliegend zurückbleibt.

## Revendications

1. Masque stratifié comprenant une couche adhésive (5), une couche d'une feuille en métal (2) adhérant à une surface supérieure de la couche adhésive, une ou plusieurs bandes adhésives (7) (7a) (7b) qui sont formées sur la longueur de la couche formant feuille en métal sur un côté opposé à la couche adhésive, la ou les bandes adhésives passant parallèlement à un bord externe de la feuille en métal et au moins une couche formant masque détachable (8) qui adhère à une surface supérieure de la ou des bandes adhésives, caractérisé en ce que ladite ou lesdites bandes adhésives sont adjacentes à une ou plusieurs zones sans adhésif (9) sur une surface de la bouche formant feuille (2) ; en ce qu'au moins l'une des zones sans adhésif est placée centralement sur la couche formant feuille ; et en ce que ladite au moins une feuille formant masque détachable (8) couvre ladite zone sans adhésif (9)

2. Stratifié selon la revendication 1, où la couche adhésive est un adhésif sensible à la pression ; et la couche formant feuille en métal est choisie dans le groupe consistant en feuilles en métal conducteur, alliages de métal conducteur et feuilles de métal plaqué pour les rendre conductrices.

3. Stratifié selon la revendication 1 ou 2, où la couche adhésive est électriquement conductrice.

4. Stratifié selon la revendication 3, où la couche adhésive est un adhésif sensible à la pression électriquement conducteur.

5. Stratifié selon l'une quelconque des revendications 1 à 4, où la couche formant feuille en métal a une série de protubérances (12) qui s'étendent à travers la couche adhésive.

6. Stratifié selon la revendication 5, où la hauteur des protubérances (12) est égale à l'épaisseur de la couche adhésive (5).

7. Stratifié selon l'une quelconque des revendications 1 à 6, où la couche formant masque a une largeur égale à ou plus petite que la largeur de la couche formant feuille.

8. Stratifié selon l'une quelconque des revendications 1 à 6, où la couche formant masque a une largeur qui est sensiblement égale à la largeur de la couche formant feuille et la couche formant masque a une série de perforations qui sont formées parallèlement aux marges de la feuille mais vers l'intérieur des marges de la feuille.

9. Stratifié selon l'une quelconque des revendications 1 à 8, où la largeur de la couche formant masque et la largeur de la ou des bandes adhésives sont égales et la largeur du masque et la largeur de la ou des bandes adhésives est plus petite que la largeur de la couche formant feuille en métal.

10. Stratifié selon l'une quelconque des revendications 1 à 9, comprenant de plus une couche de décollage (6) qui est reliée à une surface externe de la couche adhésive.

11. Stratifié selon l'une quelconque des revendications 1 à 10, où il n'y a qu'une bande adhésive (7a) qui couvre une première zone sans adhésif sur le côté supérieur de la couche formant feuille et un film détachable (13) entre ladite bande adhésive et ladite zone sans adhésif de la couche formant feuille en métal.

12. Masque stratifié selon l'une quelconque des revendications 1 à 11, où la couche formant feuille en métal est choisie dans le groupe consistant en une feuille d'argent, une feuille d'or, une feuille de platine, une feuille de palladium, une feuille de cuivre, une feuille d'aluminium, une feuille d'étain, une feuille de zinc, une feuille de cobalt, une feuille de nickel, une feuille de fer, une feuille d'acier inoxydable, une feuille de cuivre plaqué d'argent , une feuille d'aluminium plaqué d'argent, une feuille de nickel plaqué d'argent et une feuille de cuivre plaqué d'étain ; la couche adhésive est choisie dans le groupe consistant en adhésifs non électriquement conducteurs sensibles à la pression et adhésifs électriquement conducteurs sensibles à la pression ; et la couche formant masque est choisie dans le groupe consistant en films polymériques, papier couché, étoffes tissées et non tissées et feuilles de métal.

13. Masque stratifié selon la revendication 12, où une portion de la couche formant masque et de la bande adhésive, les deux ayant une largeur sensiblement égale à ou plus grande que la largeur de la zone sans adhésif, peuvent être enlevées du reste de la couche formant masque.

14. Stratifié selon l'une quelconque des revendications 1 à 4, où il y a une bande adhésive (7b) qui peut être complètement enlevée de la feuille en métal en utilisation, pour exposer ladite zone sans adhésif (9).

15. Méthode de masquage d'une surface pour l'application d'un revêtement protecteur, consistant à appliquer, à une partie de ladite surface à enduire, un masque stratifié (2, 5, 8) comprenant une feuille en métal (2) ayant une couche adhésive (5) pour le fixer à la surface (10) à masquer et comportant une couche détachable de masquage (8) montée par un autre adhésif (7a, 7b) sur le côté opposé de la feuille en métal (2) par rapport à celui contactant l'adhésif (5) et à appliquer subséquemment un revêtement de surface aux zones non masquées de la surface et à enlever au moins une partie du masque stratifié, caractérisée en ce que la partie du masque stratifié que l'on enlève est la couche de masquage (8) et de plus l'adhésif (7), (7a), (7b), après application du revêtement pour ainsi laisser exposée une zone (9) sans adhésif de la feuille en métal (2).
